# EUROPEAN PATENT SPECIFICATION

(11) **EP 3 131 124 B1**
(45) Date of publication and mention of the grant of the patent: **25.09.2019**
(21) Application number: 15181128.8
(22) Date of filing: 14.08.2015
(51) Int. Cl.: H01L 31/102, H01L 31/0304, H01L 31/0352, H01L 31/0224

(54) **INFRARED PHOTODETECTOR BASED ON RESONANT TUNNELING DIODE**
INFRAROT-PHOTODETEKTOR BASIEREND AUF EINER DIODE MIT RESONANTER TUNNELSTRUKTUR
PHOTODÉTECTEUR INFRAROUGE BASÉ SUR UNE DIODE À EFFET TUNNEL RÉSONANT

(43) Date of publication of application: 15.02.2017
(73) Proprietor: Julius-Maximilians-Universität Würzburg, 97070 Würzburg (DE)
(72) Inventor: Pfenning, Andreas, 97218 Gerbrunn (DE); Hartmann, Fabian, 97337 Dettelbach (DE); Emmerling, Monika, 97074 Würzburg (DE); Worschech, Lukas, 97072 Würzburg (DE)
(74) Representative: Lucke, Andreas

(56) References cited:
- WO-A1-2009/106595
- US-A- 5 939 729
- R. BERESFORD ET AL: "Resonant tunneling of holes in AlSb/GaSb/AlSb double-barrier heterostructures", APPLIED PHYSICS LETTERS, vol. 55, no. 7, 14 August 1989 (1989-08-14), pages 694-695, XP055252980, 2 Huntington Quadrangle, Melville, NY 11747 ISSN: 0003-6951, DOI: 10.1063/1.101801
- J.F. LAMPIN ET AL: "First resonant tunneling via a light-hole ground state", PHYSICA E - LOW-DIMENSIONAL SYSTEMS AND NANOSTRUCTURES, vol. 2, no. 1-4, 15 July 1998 (1998-07-15) , pages 453-457, XP055252985, NL ISSN: 1386-9477, DOI: 10.1016/S1386-9477(98)00093-9
- KOLLONITSCH Z ET AL: "Improved structure and performance of the GaAsSb/InP interface in a resonant tunneling diode", JOURNAL OF CRYSTAL GROWTH, ELSEVIER, AMSTERDAM, NL, vol. 287, no. 2, 25 January 2006 (2006-01-25), pages 536-540, XP028016279, ISSN: 0022-0248, DOI: 10.1016/J.JCRYSGRO.2005.10.027 [retrieved on 2006-01-25]
- LI JUN ET AL: "Design of a resonant-cavity-enhanced GaInAsSb/GaSb photodetector", SEMICONDUCTOR SCIENCE AND TECHNOLOGY, IOP PUBLISHING LTD, GB, vol. 19, no. 6, 1 June 2004 (2004-06-01), pages 690-694, XP020032704, ISSN: 0268-1242, DOI: 10.1088/0268-1242/19/6/005

## Description

### TECHNICAL FIELD

The present invention is related to photodetection and belongs to the field of semiconductor photodetectors.

### BACKGROUND

Different technologies are known to detect photons, wherein the detectable wavelength range and the sensitivity of the photodetection depend on the type and on the material of the specific photodetector which is used.

Photodetectors based on HgCdTe, for example, allow for photodetection in a range between 1 µm to 30 µm. However, HgCdTe is highly poisonous. Since HgCdTe is not RoHS compliant, its use is widely prohibited. Further, HgCdTe structures exhibit a low uniformity due to a low vapor pressure of Hg. Therefore, photodetectors based on HgCdTe suffer from a low yield due to defects and leaking currents.

To ensure that even weak optical signals can be detected it is necessary to use photodetectors which are sufficiently sensitive. For this purpose amplifiers are used, which may also be integrated into the photodetectors. Examples for photodetectors with internal amplification are resonant tunneling diodes (RTDs) combined with an absorption layer as well as avalanche-photodiodes (APDs). While APDs usually have an operating voltage between 50 V and 100 V, RTDs have an advantageously low operating voltage below 5 V.

Photodetectors which combine RTDs and internal absorption layers provide a very efficient amplification and allow for a very sensitive detection. These photodetectors also allow for a fast detection with a high time resolution, however, compared to APD they are less fast. These advantages generally result from the fact that a tunneling current of the RTD reacts very sensitively to photon induced changes in a local electrostatic potential.

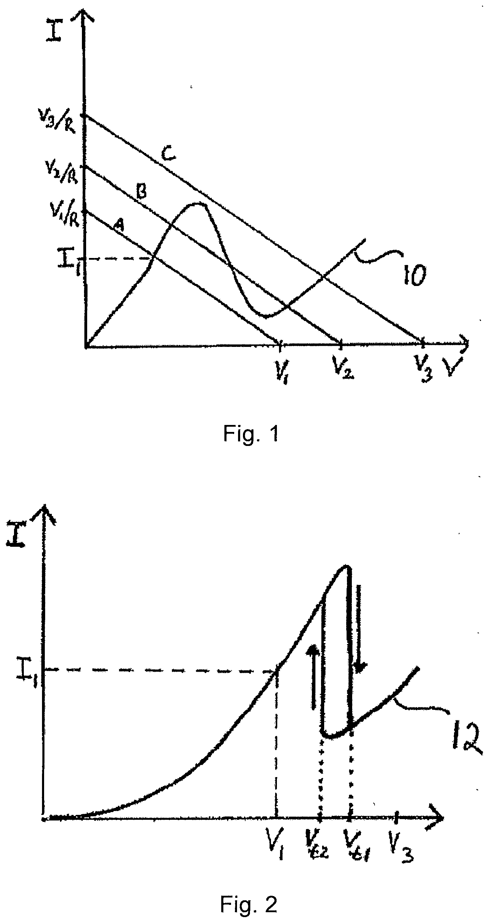

In the following a specific example of photodetection by use of RTDs, namely the so called "Geigermodus", will be explained in more detail with reference to Figs. 1 to 5. By using the Geigermodus photodetection can be performed particularly sensitive and fast. Photodetection in the Geigermodus requires a negative differential resistance (NDR) which can be provided by RTDs.

Fig. 1 shows an ideal current voltage characteristic 10 of an RTD and three load lines A, B and C. The ideal current voltage characteristic 10 has a local maximum, a local minimum and a NDR region in between where the current decreases if the voltage increases. In the NDR region the ideal current voltage characteristic 10 has a negative differential resistance (NDR).

Each of the load lines A, B and C corresponds to a different voltage V₁, V₂ and V₃ which is applied to a circuit comprising the RTD. The slope of the load lines corresponds to -1/R, wherein R is the resistance of the circuit comprising the RTD. As can be seen from Fig. 1, each of the load lines A and C intersects the ideal current voltage characteristic 10 in one point, which respectively corresponds to a stable operating point. Load line B has three intersections, wherein only the left intersection and the right intersection correspond to stable operating points. The intersection in the NDR region is unstable. Those intersections which correspond to stable operating points indicate at the y-axis the current which will actually flow through the RTD and at the x-axis the actually resulting voltage over the RTD.

The voltage of a load line, such as V₁ for load line A, and the current of the stable working point of that load line, such as current I₁ for load line A in Fig. 1, form a point (V₁; I₁) on an actual current voltage characteristic 12 of the RTD, which is illustrated in Fig. 2. The actual current voltage characteristic 12 can be obtained by applying different voltages V to the circuit comprising the RTD and by measuring for each voltage V the corresponding current I flowing through the RTD. In other words, if an external voltage is applied to the circuit comprising the RTD the actual current voltage characteristic 12 indicates the respective current which flows in stable condition.

As can be seen from Fig. 2, the actual current voltage characteristic 12 has a bi-stable region between threshold voltages Vₜ₁ and Vₜ₂ where two different stable operating conditions exist, because the resistance R is sufficiently large. Load lines obtained for voltages within the bi-stable region, e.g. load line B in Fig. 1, have three intersections with the ideal current voltage characteristic 10, wherein only two of these intersections correspond to stable working points. Load lines obtained for voltages outside the bi-stable region, e.g. load lines A and C in Fig. 1, have only one intersection with the ideal current voltage characteristic 10. For these load lines there is only one stable working point.

Referring to Fig. 2, if the externally applied voltage is continuously increased from below Vₜ₂, e.g. from V₁, the current through the RTD continuously increases and reaches a maximum just before Vₜ₁. If the voltage is further increased beyond Vₜ₁, the current abruptly drops at Vₜ₁ to a lower current and then continuously increases again. On the other hand, if the applied voltage is continuously decreased from above Vₜ₁, e.g. from V₃, to just before Vₜ₂, the current does not change abruptly again at Vₜ₁ but continuously decreases and reaches a minimum just before Vₜ₂. If the voltage is further decreased beyond Vₜ₂, the current jumps to the larger current again at Vₜ₂ and then continuously decreases again. The abrupt current changes at Vₜ₁ and at Vₜ₂ correspond to transitions to new working points.

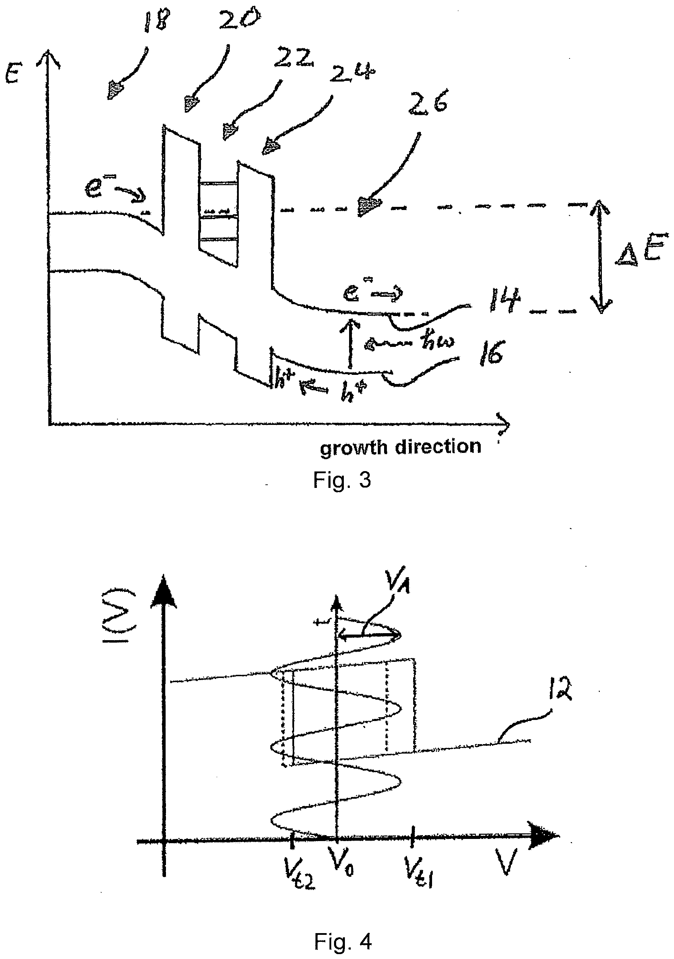

The above current switching occurring when leaving the bi-stable region can be used for an effective amplification when detecting photons, as will be explained in the following. One possibility to induce the current switching is to change the externally applied voltage or to change the resistance within the circuit. Thereby the load line is shifted or rotated in Fig. 1 with respect to the ideal current voltage characteristic 10. Another possibility is to shift the ideal current voltage characteristic 10 with respect to the load line. Such a shift can be induced by photon absorption, which will be explained with reference to Fig. 3.

Fig. 3 shows the energy of a conduction band 14 and a valence band 16 along a layer structure of an RTD having an integrated absorption layer 26. The layer structure of Fig. 3 comprises from left to right an n-doped region 18, a first barrier layer 20, an inter-barrier layer 22, a second barrier layer 24 and the absorption layer 26. The layer structure of Fig. 3 is biased by a voltage leading to an energy difference ΔE over the barrier layer structure 20, 22 and 24 in the energy bands. The inter-barrier layer 22 provides an electron well in the conduction band 14 leading to separated energy states for electrons, as is illustrated by horizontal lines in Fig. 3. Because of the n-doping movable electrons are provided in the conduction band 14 in the n-doped region 18 with an energy determined by the energy of the conduction band 14. If the energy of the movable electrons corresponds to the energy of an energy state between the barrier layers 20, 24, the electrons are not blocked at the barrier layer structure 20, 22 and 24 but can resonantly tunnel through the barrier layer structure 20, 22 and 24. In other words, if the layer structure is biased, such that the electron energy coincides with an energy state in the well the barrier layer structure 20, 22, 24 becomes permeable resulting in a resonant tunneling current.

The local peaks in the current voltage characteristics 10, 12 of Figs. 1 and 2 correspond to such a resonant tunneling current. In the NDR region, the resonant tunneling current decreases even though the voltage and therefore the energy difference ΔE increases. This is due to an increasing misalignment between the energy of the electrons and the energy state in the inter-barrier layer 22 leading to a reduced permeability of the barriers 20, 24 and therefore to a reduced resonant tunneling current.

This sensitivity of the tunneling current to a relative shift of the energy states in the well can be exploited for photodetection. If a photon is absorbed, as is illustrated in Fig. 3, an electron hole pair is created. The holes move towards the barrier layer 24 where they accumulate. These light-induced accumulated holes cause a change in the local electrostatic potential, such that the conduction band 14 and valence band 16 are energetically shifted. This leads to a shift of the energy states in the well. This change which is induced by the light-induced holes at the barrier layer 24 corresponds to a shift of the current voltage characteristic 10 of Fig. 1 and therefore to a shift of the stable working points. Hence, the photon abortion also leads to a shift of the bi-stable region in Fig. 2 such that the absorption can induce the above explained abrupt current change at Vₜ₁ or Vₜ₂.

With reference to Fig. 4, an example for a measurement in the Geigermodus using a RTD photodetector is explained. Fig. 4 shows a part of the actual current voltage characteristic 12 of Fig. 1 which is not shifted without illumination (solid line) and which is shifted under illumination (dashed lines). The actual current voltage characteristic 12 shown in Fig. 4 has an upper branch comprising one of the abovementioned two stable operating conditions and a lower branch comprising the other stable operating condition. If an alternating voltage, e.g. V(t) = V₀ + V_{A} · sin(ωt), is applied and no illumination takes place the working point can alternate on the upper branch between a lower voltage which is smaller than Vₜ₂ and an upper voltage which is larger than Vₜ₂ and smaller than Vₜ₁. In this case, the current through the RTD alternates continuously between a lower current and an upper current without abrupt current changes. In case of illumination Vₜ₂ and Vₜ₁ are shifted to the positions of the dashed lines such that the applied voltage passes both the shifted Vₜ₁ and the shifted Vₜ₁. When the applied voltage passes the shifted Vₜ₁ from left to right (i.e. from inside to outside the bi-stable region) a transition of the working point from the upper branch to the lower branch occurs. When the applied voltage afterwards passes the shifted Vₜ₂ from right to left (i.e. from inside to outside the bi-stable region) the working point is set back to the upper branch again, which corresponds to a reset-operation. After the reset-operation a further photodetection is possible. Hence, for this operation abrupt current jumps or current switchings only occur under illumination when the applied voltage passes Vₜ₁ or Vₜ₁ from inside the bi-stable region.

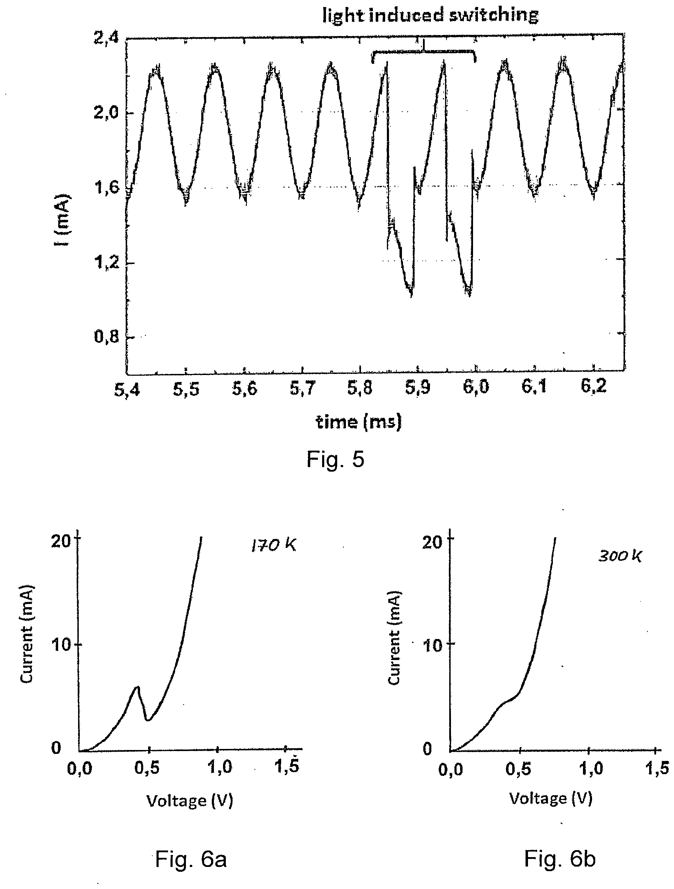

The light-induced switching is illustrated in Fig. 5 which shows the course of a current resulting for an applied voltage V(t) = V₀ + V_{A} · sin(ωt). While in periods without illumination the current does not change abruptly, abrupt changes induced by photon absorption are present in periods with illumination.

The abrupt current changes which are light-induced can be comparatively large and therefore allow for a very efficient amplification when detecting photons. In other words, the Geigermodus allows for a high amplification, because at the transition between working points a slight photon induced shift of the current voltage characteristic 10 can induce a large current change. The position, orientation and variation of the load line can be adjusted, such that only illumination above a predefined threshold is discretely detected, while illumination below the predefined threshold is not detected. In principle it is possible, that the predefined threshold allows for single photon detection. Further, depending on the frequency of the applied alternating voltage the detection can be fast and can have a high time resolution.

The above explained Geigermodus is only one example which allows for a particular sensitive and fast detection by using RTDs. However, RTDs can also be used for other advantageous types of fast and sensitive photodetection, which use the above explained phenomenon that a tunneling current sensitively reacts to illumination, because photogenerated charge carriers cause changes in a local electrostatic potential.

RTD photodetectors which offer the above advantages are described in US 2011/0068853 A1 and WO 2009/106595 A1. One of these examples comprises an AlSb/GaSb/AlSb-barrier layer structure formed on a layer of InAs. This structure can be used to detect photons in the wavelength range between 1.8 µm and 4 µm. Further examples for RTD photodetectors are provided in US 8143648 B1, US 5446293 and EP 0 706 225 A1. These photodetectors allow for photodetection in the visible and near infrared region. The detectable photon wavelength depends on the material which is used for the absorption layer 26. If the absorption layer 26 and the RTD are integrally formed they comprise materials which can be grown in a common layer structure. Examples for such layer structures are based on GaAs, InP, InAs substrates.

However, some of the above advantages of RTD photodetectors depend on the existence, magnitude and steepness of a NDR region, which depends on temperature. As a result not every RTD photodetector can be used at room temperature or without cooling. In the article *"*Resonant tunneling in AlSbGaSbAlSb and AlSbInGaSbAlSb double barrier heterostructures, J.L. Jimenez et al., Appl. Phys. Lett. 64, 2127 (1994*)"* it has been shown that the NDR region of a sample having an AlSb-GaSb-AlSb heterostructure formed on an n-doped GaSb layer is not present for temperatures above 0°. This is illustrated by Fig. 6 which shows the current voltage characteristic of the above sample at a temperature of 170 K (Fig. 6a) and at a temperature of 300 K (Fig. 6b). While the current voltage characteristic has a pronounced resonance and NDR region at 170 K, there is no NDR region at 300 K. Accordingly, the above sample is not suitable for the above described advantageous photodetection at a temperature of 300 K.

### SUMMARY OF THE INVENTION

The object of the present invention is to provide a photodetector which allows for sensitive detection of photons having a wavelength between 1,7 µm and 30 µm, wherein the detection can be performed at comparatively high temperatures. A further object is to provide a method for forming a layer structure for a corresponding photodetector. These objects are solved by the independent claims. Preferred embodiments are defined in the dependent claims.

The present invention provides a photodetector according to claim 1.

Different from prior art photodetectors which use a resonant tunneling structure, the photodetector of the present invention comprises a p-doped layer instead of a n-doped layer. Accordingly, the resonant tunneling current is not created by electrons tunneling through the barrier layer structure in the conduction band but can be provided by holes tunneling through the barrier layer structure in the valence band. Unlike in photodetectors of the prior art, the tunneling current is not controlled or changed by accumulated photon-induced holes but by photon-induced electrons which accumulate in the conduction band at the barrier layer structure or within the barrier layer structure.

At first view, using a p-doped layer leading to hole conduction instead of using a n-doped layer leading to electron conduction is disadvantageous. This is because electrons have a lower effective mass and a larger De Broglie wavelength as compared to holes. Due to their lower effective mass, electrons have better transport properties as compared to holes. And due to the larger De Broglie wavelength of electrons, being a measure for the space occupied by a particle or quasi-particle, the layer thickness in the layer structure can be larger, if a n-doping is used for electron conduction, such that the accuracy requirements for the growth of semiconductor layers are lower.

Contrary to common wisdom, the inventors have found that resonant tunneling structures which do not show a pronounced resonance or NDR region when being n-doped surprisingly can exhibit a pronounced resonance or NDR region at the same temperature when being p-doped.

This allows using a wider range of materials for the layer structures of RTD photodetectors which allow for effective photodetection by use of a NDR region at a specific temperature. Since the absorption layer and the resonant tunneling structure are integrally formed, i.e. can be comprised in a layer structure comprising layers which are deposited above each other and forming a functional unit, also the absorption layer can be selected from a wider range of materials. This allows using materials which are suitable for photoelectric absorption of photons in a range between 1,7 µm and 30 µm and which cannot be used to form layer structures having a NDR region when being n-doped or which can only have a NDR region at lower temperatures when being n-doped. Therefore, the p-doping allows that layer structures of RTD photodetectors having a NDR region can comprise materials absorbing in a range between 1,7 µm and 30 µm or that such RTD photodetectors still have the NDR region at higher temperatures. Therefore, the p-doping allows using a NDR region for effective photodetection in a wider range above 1,7 µm or at least at higher temperatures in a wider range above 1,7 µm.

Further, it is possible to use a p-doping instead of a n-doping for existing layer structures which can increase the temperature at which photodetection can be performed sufficiently sensitive.

The first p-doped layer can be used to provide holes as free charge carriers, which can resonantly tunnel through the barrier layer structure, if the layer structure is biased accordingly.

The barrier layer structure can be arranged, for example, between the absorption layer and the first p-doped layer. Alternatively, the absorption layer can also be arranged within the barrier layer structure, for example.

According to a preferred embodiment, the resonant tunneling structure is unipolar and further comprises a second p-doped layer, wherein the barrier layer structure and the absorption layer are arranged between the first p-doped layer and the second p-doped layer. An unipolar resonant tunneling structure is only doped by one doping type, in the present case p-doped, such that the resonant tunneling current is only created by hole conduction but not additionally by electron conduction. If the barrier layer structure is arranged between the first p-doped layer and the second p-doped layer, both of the p-doped layers can be used as contacts or as conductive interfaces to contacts which can be used to apply a voltage over the barrier layer structure.

The absorption layer comprises GaInAsSb and/or a GaInSb/InAs-superlattice. GaInAsSb allows for photon absorption in a range between about 1.7 µm to about 5 µm. The GaInSb/InAs-superlattice can be formed to allow for a photoelectric absorption in the wavelength range between about 2.5 µm to about 30 µm.

The integrally formed layer structure comprises GaSb and/or ternary, quaternary or quinternary compound semiconductors with a lattice constant between 6.05 Å and 6.15 Å. GaSb has a lattice constant of about 6.098 Å. In ideal cases layer structures are lattice matched to avoid defects and strain. In lattice matched layer structures different layers being grown above each other have the same lattice constant. However, for achieving a degree of defects and strain which is sufficiently low it is also possible to use a pseudo-morphous growth, wherein the difference in the lattice constants of adjacent layers is sufficiently low. Therein, the allowable difference in the lattice constants depends on the layer thickness. The thinner the layer is, the larger the difference between the lattice constants can be. In order to receive an integrally formed layer structure which can be used for photodetection, the layers which are deposited above each other and which exceed a certain thickness need to have a lattice constants sufficiently close to each other. Ternary, quaternary and quinternary compound semiconductors with a lattice constant in the above range can be grown with a sufficient thickness on GaSb to form an integral layer structure with a degree of defects and strain which is sufficiently low. Further, such materials can be suitable to be used as barrier layers, absorption layers or other layers in a layer structure comprising GaSb.

The integrally formed layer structure may be arranged on a substrate comprising GaSb. Hence, a GaSb substrate can be used as a starting point on which the layer structure comprising the resonant tunneling structure and the absorption layer can be formed or deposited.

According to a further embodiment, the barrier layers may comprise AlAsSb. This material is suitable to provide barriers for holes in the valence band and barriers for electrons in the conduction band.

According to a further embodiment, the barrier layer structure comprises an AlAsSb/GaSb/AlAsSb double barrier structure.

Alternatively or additionally, the barrier layer structure may comprise a layer which provides an electron well in the conduction band, wherein the layer is arranged at the barrier layer structure and is arranged between the barrier layer structure and the absorption layer. This allows confining photon generated electrons at or within the barrier structure. Because the barrier layer structure comprises an electron well or electron trap in the conduction band, while providing a hole tunneling barrier in the valence band, photogenerated electrons are locally confined within the hole tunneling barrier. This leads to a maximized Coulomb interaction of the photogenerated electrons, and thus to a maximized shift of the energy state in the inter-barrier layer corresponding to a resonant tunneling energy level. This may lead to a larger current signal. Because of the confinement, the lifetime of the electrons which are accumulated within the barrier layer structure and are used to control or change the resonant tunneling current can be increased. The longer the lifetime the longer is the period in which the tunneling current is changed. This may lead to a larger amplification factor. Therefore, the electron well in the conduction band can increase the sensitivity of the photodetector.

Alternatively or additionally, the barrier layer structure may comprise two spatially separated double layers, wherein each double layer may comprise a first layer of a first material (AlAsSb) providing an electron barrier in the conduction band and a first hole barrier in the valence band, and a second layer of a second material (InAs) providing an electron well in the conduction band and a second hole barrier in the valence band. The electron well in the conduction band can provide the above described advantage of an increased sensitivity. The second material can simultaneously modify the double barrier in the valence band for the holes.

According to a preferred embodiment, the second hole barrier provided by the second material is higher than the first hole barrier provided by the first material. If the height of the hole barrier is increased, the energy states between the barriers are sharper and less spread leading to a more pronounced resonance in the current voltage characteristic. This can be used to increase the sensitivity of the photodetector. A higher barrier for holes further reduces non-resonant hole tunneling through the double barrier leading to a reduced leaking current. Additionally, further non-resonant channels such as thermionic emission are drastically reduced which also leads to an increased sensitivity.

In one embodiment the barrier layer structure comprises two spatially separated double layers, wherein each double layer comprises a first layer comprising AlAsSb and a second layer comprising InAs. AlAsSb can provide a barrier for electrons in the conduction band and a barrier for the holes in the valence band, wherein InAs can provide an electron well in the valence band and can simultaneously increase the barrier height for holes in the valence band.

According to a further embodiment, at least one of the p-doped layers and the barrier layer structure can be comprised in a mesa structure, wherein the photodetector can further comprise an insulating sealing layer capping the mesa structure. Because of the mesa structure, the resonant tunneling current can be limited to a defined spatial region. The sealing layer can protect the layer structure including the resonant tunneling structure and the absorption layer and may prevent, for example, an oxidation and a formation of a conductive oxide or of a metallic film which could compromise the function of the photodetector.

The sealing layer can be formed, for example, by GaAs or InAs. GaAs does not oxidize when exposed to air and is chemically stable. Further, it is transparent for wavelengths above 900 nm, such that photons to be detected are not prevented from reaching the absorption layer.

The photodetector can further comprise a voltage or current source for biasing the resonant tunneling structure to provide a tunneling current, wherein the tunneling current is based on hole conduction, and a detection apparatus for detecting a change of the tunneling current, wherein the change is induced by photon absorption.

The present invention further comprises a method according to claim 13.

The aforementioned steps of growing can be performed in an order, such that in the layer structure a barrier layer structure, which comprises the first and second barrier layers and the inter-barrier layer is arranged, for example, between the absorption layer and the p-doped layer. In an alternative example, the steps of growing are performed in an order, such that the absorption layer is arranged within the barrier layer structure.

It is noted, that the aspect of the present invention of using a p-doping for RTD based photodetectors can also be used in combination with other absorption layers, which can comprise different materials as have been described so far and which can thus be photosensitive in other wavelength regions different from the region between 1,7 µm and 30 µm. Such other photodetectors may provide similar advantages.

While the invention has been described so far with respect to photodetectors having an integrated absorption layer, the inventive concept of using a p-doping for an RTD can also be applied to layer structures with resonant tunneling structures but without integrated absorption layers. Accordingly, the present disclosure also comprises layer structures having a p-doping and a resonant tunneling structure but no absorption layer. All embodiments or examples disclosed in this application do still form examples of the present disclosure, when the absorption layer is not present. The effect of the p-doping, namely to have a more pronounced resonance at the same temperature, may still be present without the additional absorption layer.

Further materials or material systems which are suitable for a p-doping are layer structures which can be grown on InP or GaN or are based on InP or GaN. Ternary semiconductor materials which can be integrally formed together with InP are InGaAs, InAlAs, AlAsSb, GaAsSb, for example. Further, it is possible to use layer structures of materials or material systems which are grown on a ternary quasi-substrate having a desired adjusted lattice constant. The present invention comprises also these embodiments.

### BRIEF DESCRIPTION OF THE DRAWINGS

In the following description preferred embodiments are described in detail by referring to the appended drawings. In the drawings the same reference signs are used to designate the same features.
- Fig. 1: shows an ideal current voltage characteristic of a RTD which is intersected by three different load lines.
- Fig. 2: shows an actual current voltage characteristic of the RTD.
- Fig. 3: shows an energy band diagram of a prior art resonant tunneling structure.
- Fig. 4: illustrates the use of an alternating voltage for the detections of photons using an RTD.
- Fig. 5: shows a course of a resonant tunneling current which includes light induced current switchings.
- Figs. 6a, b: show current voltage characteristics of a prior art resonant tunneling structure at different temperatures.
- Fig. 7: shows a resonant tunneling diode according to an embodiment of the present invention.
- Fig. 8: shows energy momentum diagrams for GaSb and GaAs.
- Fig. 9: is a flowchart illustrating a method for forming the RTD of Fig. 7.
- Figs. 10a-h: illustrate intermediate process stages of the method of Fig. 9.
- Fig. 11: shows a circuit diagram of a photodetector according to an embodiment of the present invention.
- Figs. 12a,: b illustrate energy band diagrams of a layer structure according to a first embodiment of the present invention.
- Figs. 13a, b: show energy band diagrams of a layer structure according to a second embodiment of the present invention.
- Figs. 14a, b: show energy band diagrams of a layer structure according to a third embodiment of the present invention.

### DETAILED DESCRIPTION OF ILLUSTRATIVE EMBODIMENTS

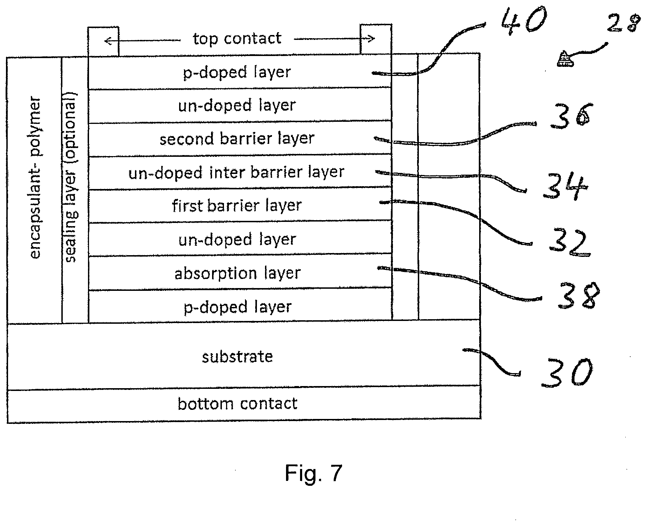

Fig. 7 shows an RTD 28 according to an embodiment of the present invention. The RTD 28 comprises an integrally formed layer structure which is arranged on a substrate 30. The layer structure comprises a barrier layer structure formed by a first barrier layer 32, an inter-barrier layer 34 and a second barrier layer 36 and further comprises an absorption layer 38. The layer structure further comprises a p-doped layer 40, wherein the barrier layer structure is arranged between the p-doped layer 40 and the absorption layer 38.

The barrier layer structure 32, 34, 36 creates a double barrier for holes in the valence band and a barrier for electrons in the conduction band. The p-doped layer 40 provides holes as free charge carriers which may resonantly tunnel through the barrier layer structure if the RTD 28 is biased with a corresponding voltage. If the RTD 28 is biased for photodetection, photons can be absorbed in the absorption layer 38 leading to the creation of an electron hole pair, wherein the holes move towards the substrate 30 and the electrons move towards the barrier layer structure 32, 34, 36. At the barrier layer structure 32, 34, 36 the electrons are accumulated and induce a change in the resonant tunneling current which is created by the holes provided by the p-doped layer 40.

Different from prior art photodetectors combining an n-doped layer or region with a resonant tunneling structure, the resonant tunneling structure of the RTD 28 is combined with a p-doping. Due to the p-doping the RTD 28 can be both employed with materials selected from a larger variety of materials and can be used for a highly sensitive photodetection above certain temperatures using an amplification mechanism depending on the existence of a NDR region.

The layer structure of the RTD 28 can be based on GaSb, for example. "Based on GaSb" means that the layer structure as functional unit can be integrally formed by sequentially growing layers on a GaSb substrate and/or that GaSb layers can be deposited in the layer structure without necessarily leading to an inoperable layer structure. In other words, the layer structure is composed of materials having lattice constants which are sufficiently close to the lattice constant of GaSb, such that the layers can be formed or deposited without significant distortions or defects above each other. For this purpose, a layer structure based on GaSb may comprise ternary, quaternary and/or quinternary compound semiconductors comprising both Ga and Sb. However, also layers of a material can be included which do not comprise any of Ga and Sb.

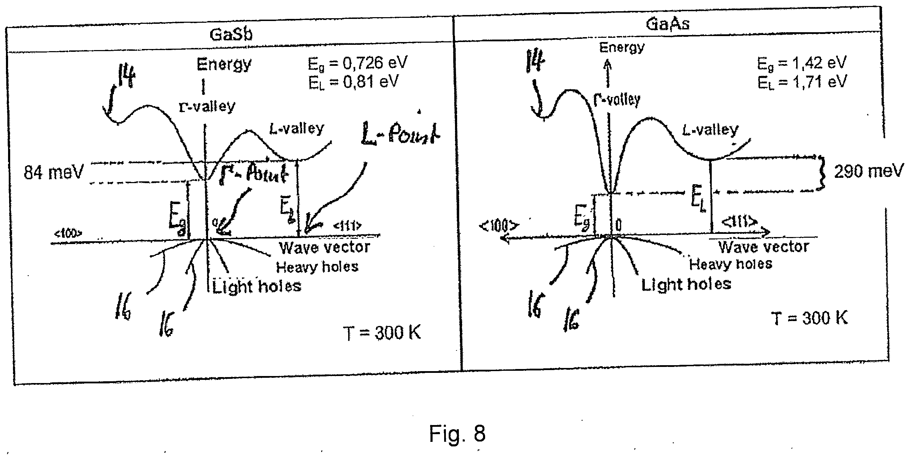

Fig. 8 shows an energy momentum diagram for GaSb on the left and for GaAs on the right. The diagrams of Fig. 8 can be used to provide an explanation, why, contrary to common wisdom, it can be advantageous to use a p-doped RTD instead of using an n-doped RTD. N-doped RTDs are based on electron conduction, wherein the electrons are transported in the conduction band 14. Within the conduction band 14 there are different stable energy states for electrons in which the electrons have a different k-vector or momentum. Such stable energy states are located at the Γ point and at the L point which are indicated in the left diagram of Fig. 8.

As can be seen from Fig. 8, the energy difference between the L point and the Γ point for electrons at 300 K is about 84 meV for GaSb and about 290 meV for GaAs. Because of the lower energy difference, it is more likely for GaSb that electrons move from the Γ point to the L point, such that in GaSb the occupation at the L point is higher as compared to GaAs. The additional occupation at the L point leads to a spreading of energy levels in and around the barrier layer structure. As a result the energy states of the system are less discrete and additional channels for tunneling exist. An additional result is an increased interaction with phonons leading to additional tunneling processes. This results in a less pronounced resonance in the current voltage characteristic. The occupation at the L point does not only depend on the energy difference between Γ point and L point but also on temperature. The higher the temperature, the higher is the electron energy and the higher is the additional occupation at the L point. Because of the lower energy difference for GaSb, at the same temperature the electron occupation at the L point, i.e. number of elections in the illustrated "L-valley", is higher as compared to GaAs. At 300 K GaSb has an occupation at the L point, which for RTDs based on GaSb can lead to a current voltage characteristic without NDR region (as shown in Fig. 6b), while RTDs based on GaAs can still have a NDR region in the current voltage characteristic at 300 K. As explained before, for sensitive photodetection a NDR region is needed. Therefore, if electron conduction, i.e. n-doping, is used, RTDs based on GaSb may not be suitable for a sensitive photodetection at 300 K, while RTDs based on GaAs may still be suitable at 300 K.

However, the inventors have found that the NDR region can be recovered without cooling by using a p-doping instead of using a n-doping without need to change the base material. As can be seen from Fig. 8, at a temperature of 300 K in GaSb the energetic separation in the conduction band 14 between the L point and the Γ point is comparatively small. Therefore, at this temperature electrons occupy the both the Γ point and the L point, whereby additional transport channels are opened for electron conduction in the conduction band 14. As a disadvantageous result the NDR region disappears or is at least less pronounced in a RTD based on GaSb which is n-doped and which is therefore operated based on electron conduction, i.e. with a resonant tunneling current provided by electrons. It has been found for RTDs based on GaSb that this disadvantage can be avoided, if a p-doping is used instead of an n-doping. These p-doped RTDs has shown a pronounced NDR region at temperatures, at which corresponding RTDs with an n-doping does not have a NDR region or at least a less pronounced NDR region. Without being bound to theory it is a possible explanation that in the barrier structure the energetic separation between a light hole miniband and a heavy hole miniband is larger due to a different mass of light holes and heavy holes. As a result there are less transport channels for hole conduction in the valence band 16 leading to a more pronounced resonance and NDC region for hole conduction at the same temperature. Because other materials have similar band structures this advantage is not limited to GaSb based systems. Instead, the p-doping can also be applied with similar advantages to other material systems.

Accordingly, it is possible that an RTD which is p-doped and operated based on hole conduction allows for a similar sensitive photodetection at higher temperatures as compared to the case, when the RTD would be n-doped and operated based on electron conduction. For example, n-doped RTDs based on GaSb may not have a NDR region at 300 K, as is illustrated in Fig. 6b, and may therefore not be suitable for sensitive photodetection at 300 K. However, when being p-doped RTDs based on GaSb can have a NDR region at 300 K and can therefore be used for sensitive photodetection even at 300 K. As will be discussed further below, integrally formed layer structures based on GaSb can include a tunneling structure and an absorption layer 38 which together allow for sensitive photodetection in the range between 1,7 µm and 30 µm.

The present invention, however, is not limited to layer structures or RTDs which are based on GaSb but also comprises embodiments with layer structures based on other materials. The use of a p-doped RTD, which at first view is a disadvantage, can allow for sensitive photodetection at higher temperatures and can allow for sensitive photodetection in a wider wavelength range without need for further cooling.

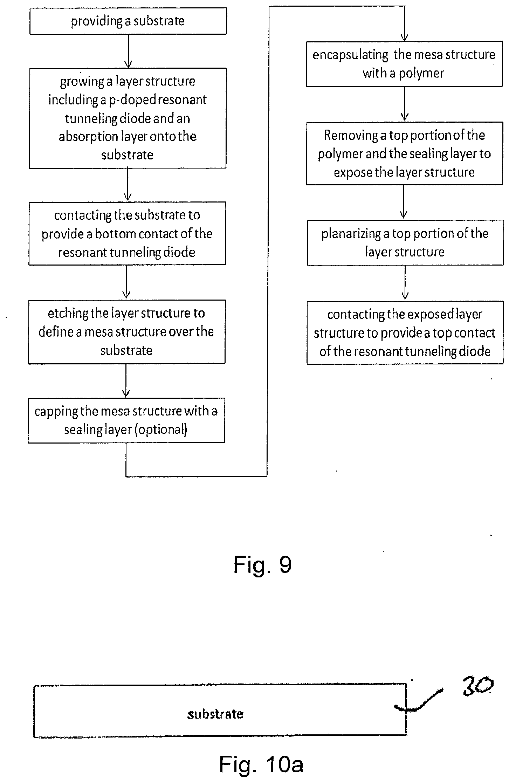

Fig. 9 illustrates a process of forming the RTD 28 of Fig. 7. The process is further illustrated by Figs. 10a - h.

In a first process step a substrate 30 is provided, as is illustrated in Fig. 10a. In one example the substrate corresponds to a GaSb wafer. The wafer may have a thickness of 500 µm, for example. In other examples the substrate can have a different thickness.

In following process steps a layer structure 50 is epitaxially grown on the substrate 30. Growing of the layer structure 50 comprises a sequential growing of the following layers on the substrate and above each other in the following sequence starting from the substrate: a p-doped layer 52, the absorption layer 38, an undoped layer 54, the first barrier layer 32, the inter-barrier layer 34, the second barrier layer 36, an undoped layer 56 and the aforementioned p-doped layer 40.

In the aforementioned example of a GaSb substrate the p-doped layer 52 can correspond to a p-doped GaSb layer. The layer can have a thickness of between 200 nm and 500 nm, for example, and can have a doping concentration of about 10¹⁸/cm³. The doping material can be Be, for example.

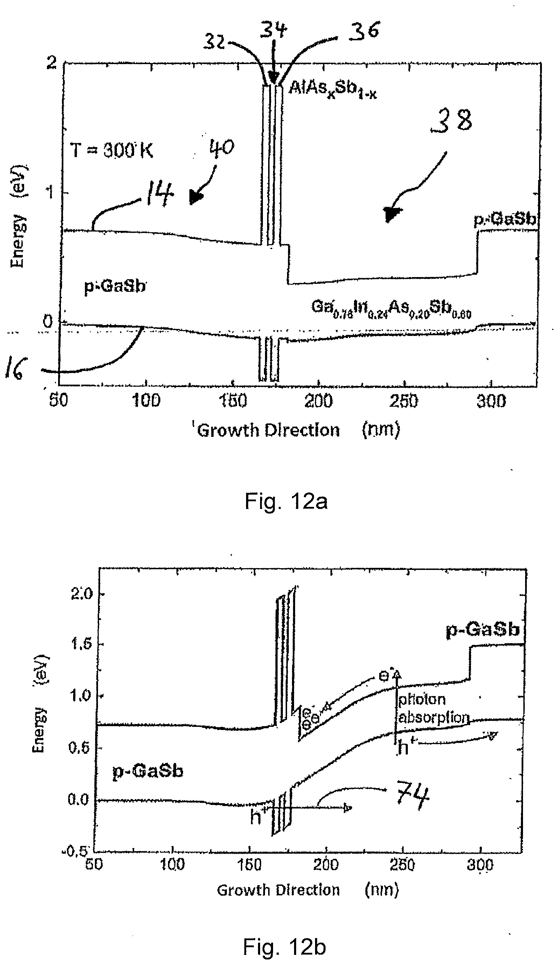

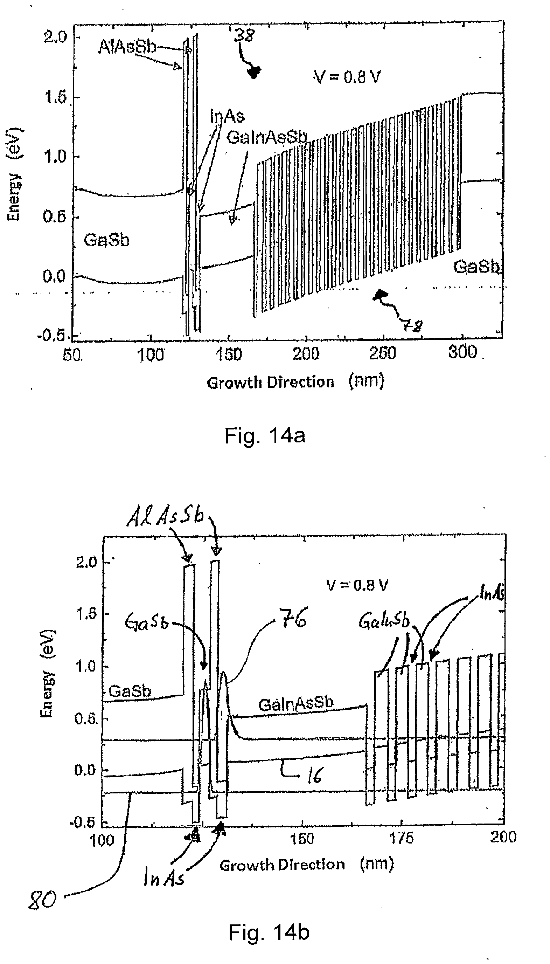

In the same example, the absorption layer 38 can correspond to a layer of GaInAsSb, as will be described further below with respect to Figs. 12a and b, or may correspond to a type-II InAs/GaInSb superlattice. Further, the absorption layer 38 may correspond to a combination of both, as is illustrated in Figs. 14a and 14b. The absorption layer 38 can have a thickness of between 10 nm and 5 µm, for example. If the absorption layer 38 is too thin, only a portion of the photons are absorbed. If the absorption layer 38 is too thick, the number of photogenerated electrons, which recombine and do not accumulate at or in the barrier structure, may be too large.

The layer 54 can correspond to an undoped GaSb layer having a thickness of between 5 nm and 40 nm, for example.

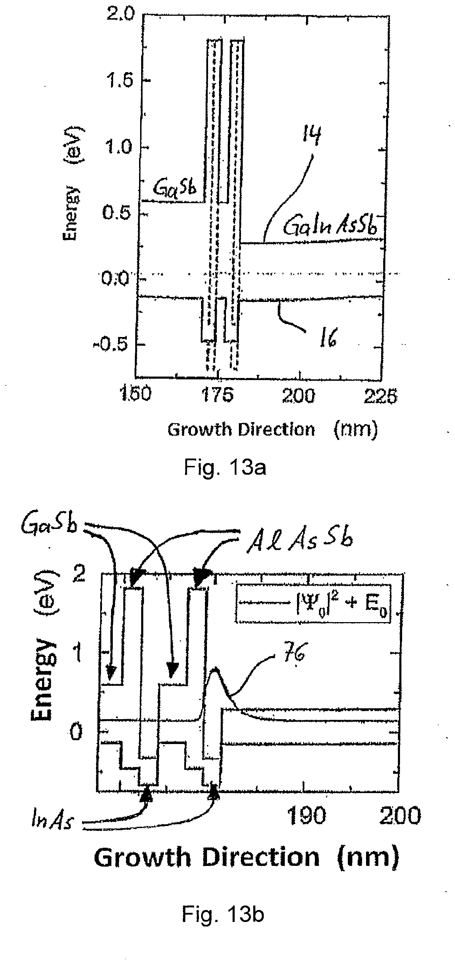

The barrier layers 32 and 36 can correspond to layers of AlAsSb. Alternatively, the barrier layers 32 and 36 can correspond in the aforementioned examples to AlSb layers. Each of the barrier layers 32 and 36 can have a thickness of between 1 nm and 10 nm, such as a thickness of about 4 nm, for example. In a further example, each of the barrier layers 32 and 36 consists of an AlAsSb/InAs double layer, as is illustrated in Figs. 13a and b. The AlAsSb layer and the InAs layer in each of the double layers 32 and 36 can have a thickness of about 2 nm, for example.

The inter-barrier layer 34 may correspond to an undoped GaSb layer of a thickness of between 1 nm and 10 nm, for example of a thickness of about 3 nm. The thickness of the inter-barrier layer 34, which provides a quantum well, is adjusted such that the energy states within the barrier structure are sufficiently separated. Because the layer structure 50 is designed for hole conduction and holes have a smaller De Broglie wavelength than electrons, the inter-barrier layer 34 is preferably thinner as compared to layer structures designed for electron conduction. For electron conduction the inter-barrier layers usually has a thickness of between 5 nm and 6 nm.

The examples described so far have a double barrier structure. However, in other examples the barrier layer structure comprises more than two barriers which also allows for resonant tunneling.

The layer 56 can correspond to an undoped GaSb layer having a thickness of between 3 nm and 40 nm, for example.

The p-doped layer 40 can correspond to a highly doped GaSb layer having a thickness of between 200 nm and 300 nm, for example. The doping concentration can correspond to 10¹⁸/cm³, for example. Be can be used as dopant, for example.

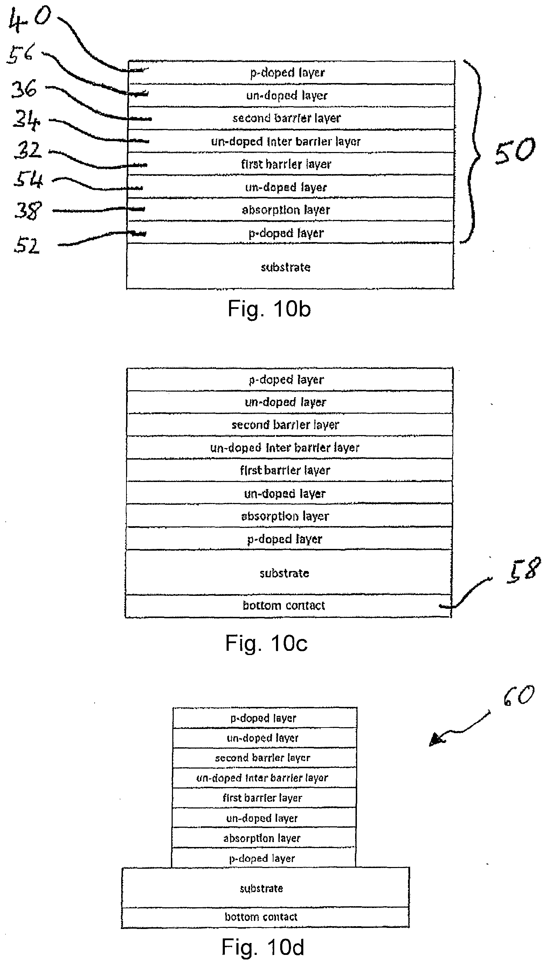

It is noted, that the absorption layer 38 does not necessarily need to be arranged between the layers 52 and 54 (as shown in Fig. 10b) but can be also arranged between other layers. According to an alternative example, the absorption layer 38 is arranged between the layers 56 and 40 (not shown). In this case, the RTD is biased in opposite direction when being operated.

As is illustrated in Fig. 10b, it is preferred that the barrier layers 32 and 36 are surrounded by the layers 54 and 56 which are undoped. This allows for a more accurate and cleaner growth which leads to an improved current voltage characteristic. However, in less preferred embodiments, the barrier layers 32 and 36 can also be surrounded by layers which are doped.

According to a further alternative, the sequence of a p-doped layer 52, 40 followed by an undoped layer 54, 56, or vice versa, can also be replaced by a single layer in which the doping concentration varies continuously from a high doping concentration to a low doping concentration which finally may arrive at a doping concentration of zero, or vice versa.

After growing the layer structure 50 the backside of the surface can be contacted by a bottom contact 58, as is illustrated in Fig. 10c. The bottom contact 58 can correspond to an Au layer, for example. Optionally, a heating step can be performed, to cause that Au diffuses into the substrate 30.

As is illustrated in Fig. 10d, the layer structure 50 can be etched in a next step to provide a mesa structure 60. The mesa structure 60 can be defined by using an optical resist and the etching can be performed by using a dry etching process. A pre- or post-treatment of the etched structures by using a wet etching is not necessary. However, it is possible to perform a wet chemical post treatment for passivating the surface, for protecting the structure from oxidizing and/or for removing conduction channels on the surface, which may be potentially present. This can be performed, for example, by passivating with SiO₂ or Si₃N₄. Alternatively or additionally, a layer of lattice matched AlGaAsSb having a thickness of some nanometers can be grown. In Fig. 10d the mesa structure 60 is etched up to the substrate 30. In other examples, the etching is less deep, for example only up to 100 nm behind the barrier structure 32, 34, 36. The mesa structure 60 preferably has a diameter of between 2 µm and 60 µm but can have other diameters in other examples. In some examples, the mesa structure 60 has a diameter of about the wavelength of the photons to be detected.

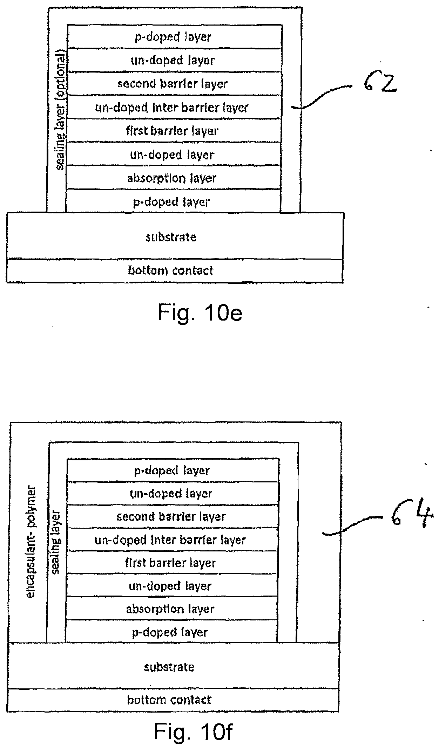

As is illustrated in Fig. 10e, the mesa structure 60 can be capped in a next optional step with a sealing layer 62. The sealing layer 62 may be composed of InAs or GaAs, for example. The sealing layer 62 can prevent that the surface of the etched layer structure 50 oxidizes and can prevent that a conductive oxide or metallic film is formed which would compromise the function of the RTD 28.

As is illustrated in Fig. 10f, the mesa structure 60 can be encapsulated in a next step by using an encapsulant 64. The encapsulant can comprise a polymer, for example benzo-cyclobutane BCB.

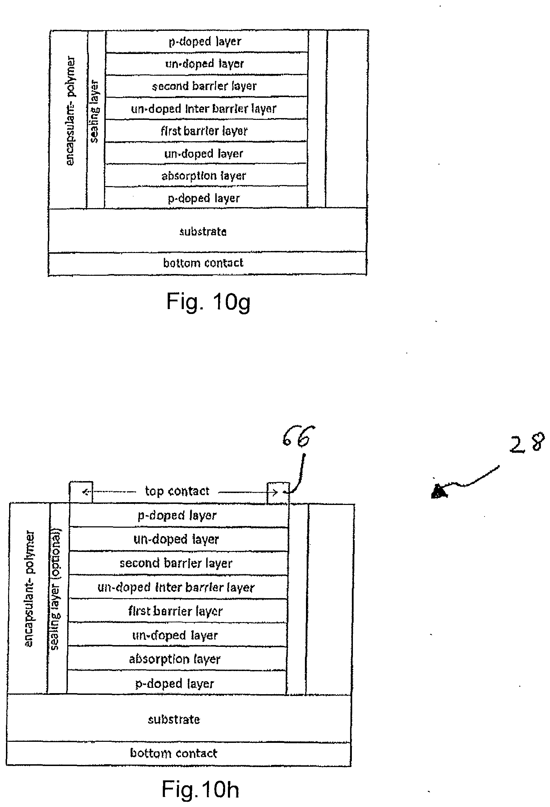

As is illustrated in Fig. 10g top portions of the encapsulant 64 and the sealing layer 62 are removed from over the layer structure 50 in a next step. Preferably, the top portion of the layer structure 50 is planarized, e.g. by a chemical-mechanical planarization CMP.

As is illustrated in Fig. 10h the top portion of the layer structure 50 is finally contacted by a top contact 66. The top contact 66 can be formed by a metallic ring contact, as is illustrated in Fig. 10h. Alternatively, the top contact 66 can also be formed by a conductive layer (not shown) which is transparent for the photons to be detected.

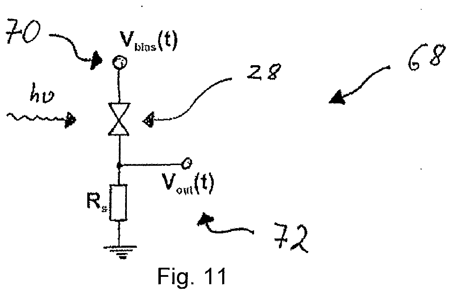

Fig. 11 shows a circuit diagram of a photodetector 68 according to an embodiment of the present invention. The photodetector 68 comprises the RTD 28, a voltage source 70 for biasing the RTD 28 and comprises a detection apparatus 72. The photodetector 68 has a serial resistance Rₛ as is indicated in Fig. 11.

The voltage source 70 can provide a constant voltage or a varying voltage for biasing the RTD 28. As a result a tunneling current can flow through the RTD 28, wherein the tunneling current is based on hole conduction. The tunneling current and/or the change thereof can be determined by measuring a voltage drop over the serial resistance Rₛ. The measurement can be performed by the detection apparatus 72 which in the example of Fig. 11 may be a voltmeter.

Alternatively, instead of a voltmeter an ampere meter can be used as detection apparatus 72. The ampere meter can be used to directly determine the current through the RTD 28. In other examples, the voltage source 70 can be replaced by a current source (not shown). In this case, the detection apparatus 62 can correspond to a voltmeter for measuring the voltage drop over the RTD 28. In this embodiment, the detection apparatus 62 is arranged between the RTD 28 and the current source (not shown).

Figs. 12a and 12b show energy diagrams of a layer structure according to a first embodiment of the present invention. The diagrams of Figs. 12a and 12b correspond to a temperature of 300 K. The layer structure of Figs. 12a and 12b comprises the following layers in the following order from left to right: a p-doped GaSb layer 40, a first barrier layer 32 of AlAsSb, an inter-barrier layer 34 of GaSb, a second barrier layer 36 of AlAsSb, an absorption layer 38 of GaInAsSb and a p-doped layer of GaSb. It is noted that the order does not correspond to the order of Fig. 10b.

The absorption layer 38 of the example of Fig. 12 has a thickness of about 110 nm. In Fig. 12a no bias is applied to the layer structure and in Fig. 12b a bias is applied leading to a resonant tunneling current 74 based on hole conduction through the double barrier in the valence band 16. In case of photon absorption in the absorption layer 38 the photo excited electrons move towards the double barrier in the conduction band 14 because of the applied bias.

As is indicated in Figs. 12a and b, between the absorption layer 38 and the adjacent layers, e.g. GaSb layers, the valence band 16 has only small offsets which are close to zero whereas the conduction band 14 has comparatively large offsets. One of the large offsets in the conduction band 14 forms an electron barrier in the conduction band 14 in addition to the double barrier in the conduction band 14. This additional electron barrier can help to prevent the photogenerated electrons from tunneling through the double barrier in the conduction band 14. Accordingly, it is possible that the tunneling current 74 can be effectively created or developed in the valence band 16 while the electrons accumulate in the triangular well created at the additional electron barrier close to the double barrier structure in the conductance band 14 without tunneling through the double barrier, as indicated in Fig. 12b. The accumulated electrons cause a slight energetic distortion of the double barriers by a variation of the local electrostatic potential leading to a change of the current voltage characteristic and therefore to a change of the tunneling current 74. This allows for efficient detection of the photons which create photo excited electrons.

Figs. 13a and 13b show a layer structure according to a second embodiment. The layer structure of Figs. 13a and 13b differs from the layer structure of Figs. 12a and 12b in that each of the AlAsSb barrier layers is replaced by a double layer having a layer of InAs and a layer of AlAsSb, as is illustrated in Figs. 13b. The resulting change in the conduction band 14 and in the valence band 16 with respect to the layer structure of Fig. 12 is indicated by dashed lines in Fig. 13a. The additional layers of InAs provide electron wells in the conduction band 14 and increase the barriers in the valence band 16. Because of the electron wells in the conduction band 14, the accumulated photon excited electrons can be confined in front of the double barrier in the conductance band 14. Fig. 13b shows the wave function 76 of an electron which is confined in a well provided by a layer of InAs. Because the InAs layer and therefore the well is part of the barrier structure, photogenerated electrons can be confined or localized in close proximity to the quantum well for holes which is provided by the barrier structure, such that the Coulomb interaction can be increased. Thereby also the change of the resonant tunneling current can be increased which can lead to a larger detection signal and to a higher amplification. Further, because of the confinement, the lifetime of accumulated electrons can be increased leading to a longer period in which the resonant tunneling current is changed. This can contribute to a further amplification of the detection signal, because the detection signal can be generated based on an integration over time of the resonant tunneling current or the change thereof. The electron wells can therefore strongly contribute to increase the sensitivity for photodetection even further.

The InAs layers in the example of Fig. 13 not only provide wells in the conduction band 14 but simultaneously increase the barrier height in the valence band 16. This reduces the non-resonant tunneling of holes through the barrier structure, such that an undesired leaking current can be reduced more effectively. Further, the increased barrier height leads to sharper energy states for holes in the well which is provided between the barrier layers in the valence band 16. This leads to a current voltage characteristic with a more pronounced resonance and NDR region. This further increases the sensitivity or allows detecting with the same sensitivity at higher temperatures.

Figs. 14a and 14b show an energy band diagram of a layer structure according to a third embodiment which is biased by a voltage of 0.8 V. The layer structure of the third embodiment differs from the first and second embodiments of Figs. 12 and 13 in that the absorption layer 38 further comprises a superlattice 78. The superlattice comprises a layer sequence of alternating layers of GaInSb and InAs. In the example of Fig. 14 the superlattice 78 comprises 26 layers of GaInSb and 27 layers of InAs. The total thickness of this superlattice 78 in the illustrated example is about 130 nm. Between the superlattice 78 and the double barrier, the absorption layer 38 comprises a layer of GaInAsSb having a thickness of about 35 nm.

The superlattice 78 provides the advantage that the effective band gap for photon absorption can be specifically adjusted. In the example of a type-II InAs/GaInSb superlattice the absorption wavelength can be specifically adjusted in a range between 3 µm and 30 µm. The adjustment of the effective absorption wavelength of a superlattice 78 can be performed by adjusting the thickness of the individual layers of the superlattice 78. The layer of GaInAsSb adjacent to the double barrier provides the advantage of having an electron well in front of the double barrier which allows effectively accumulating the electrons at the double barrier and preventing them from tunneling through the double barrier in the conduction band 14. This increases the detection signal and reduces the leaking current which leads to a higher sensitivity.

Further, the sequence "GaSb-barrier layer structure-GaInAsSb" allows for an efficient tunneling in the valence band 16, because directly behind the barrier layer structure there is no significant offset in the valence band 16 which could impede the hole conduction. Besides the wave function 76 of a confined electron Fig. 14b shows a wave function 80 of a hole which is tunneling through the double barrier in the conduction band 16.

The present invention has been described in detail with respect to illustrative embodiments and examples. However, the scope of the present invention is not limited to the described examples but is determined by the scope of the appended claims. It is further noted that different examples and embodiments of the present invention which have not been described in detail may contain one or more of the described features in different combinations. For example, it is possible to use the absorption layer 38 of the third embodiment instead of that of the first embodiment in the layer structure of Fig 13.

### LIST OF REFERENCE SIGNS

- 10: ideal current voltage characteristic
- 12: actual current voltage characteristic
- 14: conduction band
- 16: valence band
- 18: n-doped region
- 20: first barrier layer
- 22: inter-barrier layer
- 24: second barrier layer
- 26: absorption layer
- 28: resonant tunneling diode (RTD)
- 30: substrate
- 32: first barrier layer
- 34: inter-barrier layer
- 36: second barrier layer
- 38: absorption layer
- 40, 52: p-doped layer
- 50: layer structure
- 54, 56: undoped layer
- 58: bottom contact
- 60: mesa structure
- 62: sealing layer
- 64: encapsulant
- 66: top contact
- 68: photodetector
- 70: voltage source
- 72: detection apparatus
- 74: tunneling current
- 76: electron wave function
- 78: superlattice
- 80: hole wave function

## Claims

1. A photodetector (68) comprising a layer structure for photodetection, wherein the layer structure is integrally formed and includes
- a resonant tunneling structure for hole tunneling in the valence band, wherein the resonant tunneling structure comprises
• a barrier layer structure for accumulating photon-induced electrons in the conduction band at the barrier layer structure or within the barrier layer structure, wherein the barrier layer structure comprises at least two barrier layers (32, 36) separated by at least one inter-barrier layer (34), and
• a first p-doped layer (40), and
- an absorption layer (38),wherein the absorption layer (38) comprises GaInAsSb allowing for photoelectric absorption of photons in a range between 1,7 µm and 5 µm and/or comprises a GaInSb/InAs-superlattice allowing for photoelectric absorption of photons in a range between 2,5 µm and 30 µm, wherein the integrally formed layer structure comprises GaSb and/or ternary, quaternary or quinternary compound semiconductors with a lattice constant between 6,05 Å and 6,15 Å and/or is based on GaSb.

2. The photodetector (68) of claim 1, wherein the resonant tunneling structure is unipolar and further comprises a second p-doped layer (52), wherein the barrier layer structure and the absorption layer (38) are arranged between the first p-doped layer (40) and the second p-doped layer (52).

3. The photodetector of one of the preceding claims, wherein the integrally formed layer structure is arranged on a substrate (30) comprising GaSb.

4. The photodetector (68) of one of the preceding claims, wherein the barrier layers (32, 36) comprise AlAsSb.

5. The photodetector (68) of one of the preceding claims, wherein the barrier layer structure comprises an AlAsSb/GaSb/AlAsSb double barrier structure.

6. The photodetector (68) of one of the preceding claims, wherein the layer structure comprises a layer which provides an electron well in the conduction band (14), wherein the layer is arranged at the barrier layer structure and is arranged between the barrier layer structure and the absorption layer (38).

7. The photodetector (68) of one of the preceding claims, wherein the barrier layer structure comprises two spatially separated double layers (32, 36), wherein each double layer (32, 36) comprises
- a first layer of a first material (AlAsSb) providing an electron barrier in the conduction band (14) and a first hole barrier in the valence band (16), and
- a second layer of a second material (InAs) providing an electron well in the conduction band (14) and a second hole barrier in the valence band (16).

8. The photodetector (68) of claim 7, wherein the second hole barrier is higher than the first hole barrier.

9. The photodetector (68) of one of the preceding claims, wherein the barrier layer structure comprises two spatially separated double layers (32, 36), wherein each double layer (32, 36) comprises
- a first layer comprising AlAsSb and
- a second layer comprising InAs.

10. The photodetector (68) of one of the preceding claims, wherein at least one of the p-doped layers (40, 52) and the barrier layer structure are comprised in a mesa structure (60), wherein the photodetector (68) further comprises an insulating sealing layer (62) capping the mesa structure (60).

11. The photodetector (68) of claim 10, wherein the sealing layer (62) is formed by GaAs or InAs.

12. The photodetector (68) of one of the preceding claims, further comprising
- a voltage or current source (70) for biasing the resonant tunneling structure to provide a tunneling current (74), wherein the tunneling current (74) is based on hole conduction,
- a detection apparatus (72) for detecting a change of the tunneling current (74), wherein the change is induced by photon absorption.

13. A method for forming a layer structure for a photodetector (68), said method comprising the following steps:
- providing a substrate (30),
- growing a layer structure (50) including a resonant tunneling structure over the substrate, said growing comprising the following steps:
• growing a resonant tunneling structure for hole tunneling in the valence band, comprising
o growing a p-doped layer (40),
o growing a barrier layer structure for accumulating photon-induced electrons in the conduction band at the barrier layer structure or within the barrier layer structure, comprising
▪ growing a first barrier layer (32),
▪ growing an inter-barrier layer (34) over the first barrier layer (32),
▪ growing a second barrier layer (36) over the inter-barrier layer (34), and
• growing an absorption layer (38),wherein the absorption layer (38) comprises GaInAsSb allowing for photoelectric absorption of photons in a range between 1,7 µm and 5 µm and/or comprises a GaInSb/InAs-superlattice allowing for photoelectric absorption of photons in a range between 2,5 µm and 30 µm, wherein the layer structure comprises GaSb and/or ternary, quaternary or quinternary compound semiconductors with a lattice constant between 6,05 Å and 6,15 Å and/or is based on GaSb.

## Patentansprüche

1. Fotodetektor (68), der eine Schichtstruktur zur Fotodetektion umfasst, wobei die Schichtstruktur integral gebildet ist und umfasst
- eine resonante Tunnelstruktur zum Loch-Tunneln im Valenzband, wobei die resonante Tunnelstruktur umfasst
• eine Sperrschichtstruktur zum Ansammeln von photoneninduzierten Elektronen im Leitungsband an der Sperrschichtstruktur oder innerhalb der Sperrschichtstruktur, wobei die Sperrschichtstruktur mindestens zwei Sperrschichten (32, 36) umfasst, die durch mindestens eine Zwischensperrschicht (34) getrennt sind, und
• eine erste p-dotierte Schicht (40), und
- eine Absorptionsschicht (38), wobei die Absorptionsschicht (38) GaInAsSb enthält, das die fotoelektrische Absorption von Photonen in einem Bereich zwischen 1,7 µm und 5 µm ermöglicht und/oder ein GaInSb/InAs-Supergitter umfasst, das die fotoelektrische Absorption von Photonen in einem Bereich zwischen 2,5 µm und 30 µm ermöglicht, wobei die integral gebildete Schichtstruktur GaSb und/oder ternäre, quaternäre oder quinternäre Verbindungs-Halbleiter mit einer Gitterkonstanten zwischen 6,05 Å und 6,15 Å und/oder auf GaSb beruht.

2. Fotodetektor (68) nach Anspruch 1, wobei die resonante Tunnelstruktur unipolar ist und ferner eine zweite p-dotierte Schicht (52) umfasst, wobei die Sperrschichtstruktur und die Absorptionsschicht (38) zwischen der ersten p-dotierten Schicht (40) und der zweiten p-dotierten Schicht (52) angeordnet sind.

3. Fotodetektor nach einem der vorherigen Ansprüche, wobei die integral gebildete Schichtstruktur auf einem Substrat (30) angeordnet ist, das GaSb enthält.

4. Fotodetektor (68) nach einem der vorherigen Ansprüche, wobei die Sperrschichten (32, 36) AlAsSb enthalten.

5. Fotodetektor (68) nach einem der vorherigen Ansprüche, wobei die Sperrschichtstruktur eine AlAsSb/GaSb/AlAsSb-Doppelsperrschichtstruktur umfasst.

6. Fotodetektor (68) nach einem der vorherigen Ansprüche, wobei die Schichtstruktur eine Schicht enthält, die für eine Elektronenquelle im Leitungsband (14) sorgt, wobei die Schicht an der Sperrschichtstruktur angeordnet ist und zwischen der Sperrschichtstruktur und der Absorptionsschicht (38) angeordnet ist.

7. Fotodetektor (68) nach einem der vorherigen Ansprüche, wobei die Sperrschichtstruktur zwei räumlich getrennte Doppelschichten (32, 36) umfasst, wobei jede Doppelschicht (32, 36) umfasst
- eine erste Schicht eines ersten Materials (AlAsSb), das für eine Elektronensperre im Leitungsband (14) und eine erste Lochsperre in Valenzband (16) sorgt, und
- eine zweite Schicht eines zweiten Materials (InAs), das für eine Elektronenquelle im Leitungsband (14) und eine zweite Lochsperre im Valenzband (16) sorgt.

8. Fotodetektor (68) nach Anspruch 7, wobei die zweite Lochsperre höherer als die erste Lochsperre ist.

9. Fotodetektor (68) nach einem der vorherigen Ansprüche, wobei die Sperrschichtstruktur zwei räumlich getrennte Doppelschichten (32, 36) umfasst, wobei jede Doppelschicht (32, 36) umfasst
- eine erste Schicht, die AlAsSb enthält, und
- eine zweite Schicht, die InAs enthält.

10. Fotodetektor (68) nach einem der vorherigen Ansprüche, wobei mindestens eine der p-dotierten Schichten (40, 52) und die Sperrschichtstruktur in einer Mesa-Struktur (60) enthalten sind, wobei der Fotodetektor (68) ferner eine isolierende Dichtungsschicht (62) umfasst, die die Mesa-Struktur (60) abdeckt.

11. Fotodetektor (68) nach Anspruch 10, wobei die Dichtungsschicht (62) durch GaAs oder InAs gebildet wird.

12. Fotodetektor (68) nach einem der vorherigen Ansprüche, ferner umfassend
- eine Spannungs- oder Stromquelle (70) zum Vorspannen der resonanten Tunnelstruktur, um für einen Tunnelstrom (74) zu sorgen, wobei der Tunnelstrom (74) auf Lochleitung beruht,
- eine Erfassungsvorrichtung (72) zum Erfassen einer Änderung des Tunnelstroms (74), wobei die Änderung durch Photonenabsorption induziert wird.

13. Verfahren zum Bilden einer Schichtstruktur für einen Fotodetektor (68), wobei das Verfahren die folgenden Schritte umfasst:
- Bereitstellen eines Substrats (30),
- Aufwachsenlassen einer Schichtstruktur (50), einschließlich einer resonanten Tunnelstruktur über dem Substrat, wobei das Aufwachsenlassen die folgenden Schritte umfasst:
• Aufwachsenlassen einer resonanten Tunnelstruktur für Lochtunnelung im Valenzband, umfassend
∘ Aufwachsenlassen einer p-dotierten Schicht (40),
∘ Aufwachsenlassen einer Sperrschichtstruktur zum Ansammeln von photon-induzierten Elektronen im Leitungsband an der Sperrschichtstruktur oder innerhalb der Sperrschichtstruktur, umfassend
▪ Aufwachsenlassen einer ersten Sperrschicht (32),
▪ Aufwachsenlassen einer Zwischensperrschicht (34) über der ersten Sperrschicht (32),
▪ Aufwachsenlassen einer zweiten Sperrschicht (36) über der Zwischensperrschicht (34), und
• Aufwachsenlassen einer Absorptionsschicht (38), wobei die Absorptionsschicht (38) GaInAsSb enthält, was die fotoelektrische Absorption von Photonen in einem Bereich zwischen 1,7 µm und 5 µm ermöglicht und/oder ein GaInSb/InAs-Supergitter umfasst, das die fotoelektrische Absorption von Photonen in einem Bereich zwischen 2,5 µm und 30 µm ermöglicht, wobei die Schichtstruktur GaSb und/oder ternäre, quaternäre oder quinternäre Verbund-Halbleiter mit einer Gitterkonstante zwischen 6,05 Ä und 6,15 Ä umfasst und/oder auf GaSb beruht.

## Revendications

1. Photodétecteur (68) comprenant une structure de couche pour photodétection, dans lequel la structure de couche est formée intégralement et comprend
- une structure à tunnel de résonance pour la tunnelisation de trou dans la bande de valence, dans lequel la structure à tunnel de résonance comprend
• une structure de couche de barrière pour accumuler des électrons induits par photon dans la bande de conduction au niveau de la structure de couche de barrière ou dans la structure de couche de barrière, la structure de couche de barrière comprenant au moins deux couches de barrière (32, 36) séparées par au moins une couche inter-barrière (34), et
• une première couche dopée p (40), et
- une couche d'absorption (38), la couche d'absorption (38) comprenant GaInAsSb permettant l'absorption photoélectrique de photons dans une plage comprise entre 1,7 µm et 5 µm et/ou comprend un superréseau de GaInSb/InAs permettant l'absorption photoélectrique de photons dans une plage comprise entre 2,5 µm et 30 µm, la structure de couche formée intégralement comprend GaSb et/ou des semi-conducteurs à composé ternaire, quaternaire ou quinternaire avec un paramètre cristallin compris entre 6,05 Å et 6,15 Å et/ou est à base de GaSb.

2. Photodétecteur (68) selon la revendication 1, dans lequel la structure à tunnel de résonance est unipolaire et comprend en outre une deuxième couche dopée p (52), dans lequel la structure de couche de barrière et la couche d'absorption (38) sont agencées entre la première couche dopée p (40) et la deuxième couche dopée p (52).

3. Photodétecteur selon l'une des revendications précédentes, dans lequel la structure de couche intégralement formée est agencée sur un substrat (30) comprenant GaSb.

4. Photodétecteur (68) selon l'une des revendications précédentes, dans lequel la couche de barrières (32, 36) comprend AlAsSb.

5. Photodétecteur (68) selon l'une des revendications précédentes, dans lequel la structure de couche de barrière comprend une structure de double barrière AlAsSb/GaSb/AlAsSb.

6. Photodétecteur (68) selon l'une des revendications précédentes, dans lequel la structure de couche comprend une couche qui fournit un puits à électrons dans la bande de conduction (14), dans lequel la couche est agencée au niveau de la structure de couche de barrière et est agencée entre la structure de couche de barrière et la couche d'absorption (38).

7. Photodétecteur (68) selon l'une des revendications précédentes, dans lequel la structure de couche de barrière comprend deux doubles couches spatialement séparées (32, 36), dans lequel chaque double couche (32, 36) comprend
- une première couche d'un premier matériau (AlAsSb) fournissant une barrière d'électrons dans la bande de conduction (14) et une première barrière de trou dans la bande de valence (16), et
- une deuxième couche d'un deuxième matériau (InAs) fournissant un puits d'électron dans la bande de conduction (14) et une deuxième barrière de trou dans la bande de valence (16).

8. Photodétecteur (68) selon la revendication 7, dans lequel la deuxième barrière de trou est plus haute que la première barrière de trou.

9. Photodétecteur (68) selon l'une des revendications précédentes, dans lequel la structure de couche de barrière deux doubles couches spatialement séparées (32, 36), dans lequel chaque double couche (32, 36) comprend
- une première couche comprenant AlAsSb et
- une deuxième couche comprenant InAs.

10. Photodétecteur (68) selon l'une des revendications précédentes, dans lequel au moins l'une des couches dopées p (40, 52) et la structure de couche de barrière sont comprises dans une structure de mesa (60), dans le photodétecteur (68) comprenant en outre une couche de scellement isolante (62) recouvrant la structure de mesa (60).

11. Photodétecteur (68) selon la revendication 10, dans lequel la couche d'étanchéité (62) est formée de GaAs ou InAs.

12. Photodétecteur (68) selon l'une des revendications précédentes, comprenant en outre
- une source de tension ou de courant (70) pour polariser la structure à tunnel de résonance pour fournir un courant tunnel (74), le courant tunnel (74) étant basé sur la conduction de trou,
- un appareil de détection (72) pour détecter un changement du courant tunnel (74), le changement étant induit par absorption de photons.

13. Procédé de formation d'une structure de couche pour un photodétecteur (68), ledit procédé comprenant les étapes suivantes :
- la fourniture d'un substrat (30),
- la croissance d'une structure de couche (50) comprenant une structure à tunnel de résonance sur le substrat, ladite croissance comprenant les étapes suivantes :
• la croissance d'une structure à tunnel de résonance pour la tunnelisation de trou dans la bande de valence, comprenant
∘ la croissance d'une couche dopée p (40),
∘ la croissance d'une structure de couche de barrière pour accumuler des électrons induits par photon dans la bande de conduction au niveau de la structure de couche de barrière ou dans la structure de couche de barrière, comprenant
a la croissance d'une première couche de barrière (32),
a la croissance d'une couche inter-barrière (34) sur la première couche de barrière (32),
▪ la croissance d'une deuxième couche de barrière (36) sur la couche inter-barrière (34), et
• la croissance d'une couche d'absorption (38), la couche d'absorption (38) comprenant GaInAsSb permettant l'absorption photoélectrique de photons dans une plage comprise entre 1,7 µm et 5 µm et/ou comprend un superréseau de GaInSb/InAs permettant l'absorption photoélectrique de photons dans une plage comprise entre 2,5 µm et 30 µm, dans lequel la structure de couche comprend GaSb et/ou des semi-conducteurs à composé ternaire, quaternaire ou quinternaire avec un paramètre cristallin compris entre 6,05 Å et 6,15 Å et/ou est à base de GaSb.
